Europäisches Patentamt

European Patent Office

Office européen des brevets

(19)

(11) **EP 1 098 374 B1**

(12) **EUROPEAN PATENT SPECIFICATION**

(45) Date of publication and mention
of the grant of the patent:
**08.09.2004 Bulletin 2004/37**

(51) Int Cl.⁷: **H01L 33/00**, G02B 5/28

(21) Application number: **00870255.7**

(22) Date of filing: **31.10.2000**

(54) **Optical filter and Resonant Cavity LED comprising the said optical filter**

Optisches Filter und Resonanzhohlraum-LED mit diesem Filter

Filtre optique et LEC à cavité résonante avec ce filtre optique

(84) Designated Contracting States:
**BE DE FR GB**

(30) Priority: **05.11.1999 EP 99870231**

(43) Date of publication of application:
**09.05.2001 Bulletin 2001/19**

(73) Proprietors:
• **INTERUNIVERSITAIR MICRO-ELEKTRONICA CENTRUM VZW**
**3001 Heverlee (BE)**
• **Universiteit Gent**
**9000 Gent (BE)**

(72) Inventors:
• **Bienstman, Peter**
**9090 Melle (BE)**
• **Baets, Roel**
**9800 Deinze (BE)**

(74) Representative: **Van Malderen, Joelle et al**
**Office Van Malderen,**
**Place Reine Fabiola 6/1**
**1083 Bruxelles (BE)**

(56) References cited:
**EP-A- 0 442 738** **EP-A- 0 550 963**
**US-A- 4 756 602**

• **HUNT N E J ET AL: "EXTREMELY NARROW SPECTRAL WIDTHS FROM RESONANT CAVITY LIGHT-EMITTING DIODES (RCLEDS) SUITABLE FOR WAVELENGTH-DIVISION MULTIPLEXING AT 1.3 MUM AND 1.55 MUM" INTERNATIONAL ELECTRON DEVICES MEETING (IEDM),US,NEW YORK, IEEE, 1992, pages 651-654, XP000687513 ISBN: 0-7803-0818-2**
• **BOCKSTAELE R ET AL: "RESONANT CAVITY LED'S OPTIMIZED FOR COUPLING TO POLYMER OPTICAL FIBERS" IEEE PHOTONICS TECHNOLOGY LETTERS,US,IEEE INC. NEW YORK, vol. 11, no. 2, February 1999 (1999-02), pages 158-160, XP000803414 ISSN: 1041-1135**
• **BIENSTMAN P ET AL: "THE RC2LED: A NOVEL RESONANT-CAVITY LED DESIGN USING A SYMMETRIC RESONANT CAVITY IN THE OUTCOUPLING REFLECTOR" IEEE JOURNAL OF QUANTUM ELECTRONICS, IEEE INC. NEW YORK, US, vol. 36, no. 6, June 2000 (2000-06), pages 669-673, XP000959605 ISSN: 0018-9197**

## Description

### Field of the invention

The present invention relates to a system for at least guiding or transferring a beam of electromagnetic radiation, said system comprising of planar media, more in particular a stack of dielectric media with a plurality of refractive indices and thicknesses. Said electromagnetic radiation can be light, in which case said system is denoted an optical system.

### Background of the invention

Recently, resonant cavity light emitting diodes have attracted considerable interest, mainly because of the possibility of increased extraction efficiency as compared to standard LEDs. Record efficiencies as high as 20 % have been reported e.g. in H. De Neve *et al., "Recycling of Guided Mode Light Emission in Planar Microcavity Light Emitting Diodes",* Appl. Phys. Lett., vol. 70, no. 7, pp. 799-801, 1997. However, these devices exhibit a wide radiation pattern, making them less suited to fiber applications.

In the past, efforts have been undertaken to design resonant cavity light emitting diodes with a narrower radiation pattern, as explained e.g. in R. Bockstaele *et al, "Resonant Cavity LED's Optimized for Coupling to Polymer Optical Fibers",* IEEE Phot. Techn. Lett., vol. 11, pp. 158-160, 1999. This approach involves growing an undertuned cavity, i.e. a cavity that is too short as compared to the resonance wavelength. This yields narrower radiation patterns, but unfortunately at the expense of lower extraction efficiencies, since the microcavity resonance only enhances a limited subset of the spectral and angular spectrum emitted by the active layer.

### Aim of the invention

It is an aim of the invention to provide a system showing such properties such that they can at least be exploited in the design of resonant cavities with narrow radiation patterns.

### Summary of the invention

A system designed for guiding a beam of electromagnetic radiation having a vacuum wavelength $\lambda_0$, according to the invention, is defined in claim 1.

A resonant cavity light emitting diode, according to the invention, is defined in claim 7.

Preferred embodiments of the invention are defined in the dependent claims.

### Brief description of the drawings

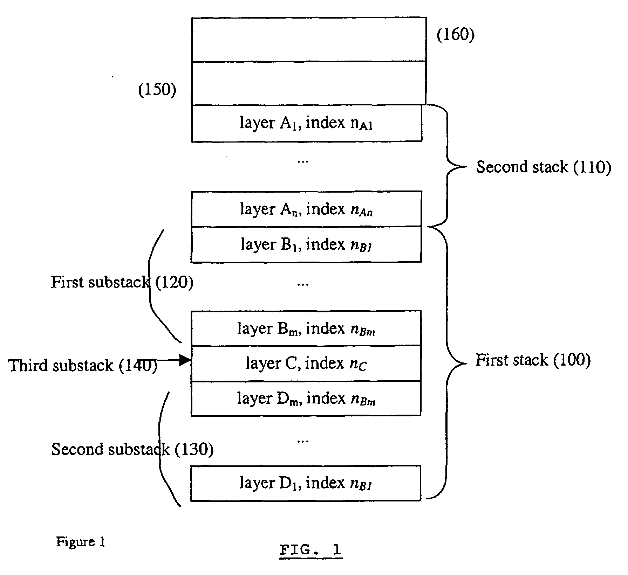

Figure 1 shows a first stack (100), comprising a first substack (120) and a second substack (130). Said first and second substacks are separated by a third substack (140). Said substacks comprise dielectric layers. In an embodiment of the invention a second stack (110) of dielectric layers is present, said second stack being attached to said first stack. In a further embodiment of the invention an electromagnetic radiation generating layer (150) is attached to said second stack. In yet another embodiment to said electromagnetic generating layer a third structure (160) is attached, said third structure can be but is not limited to be a metal reflector or a grating.

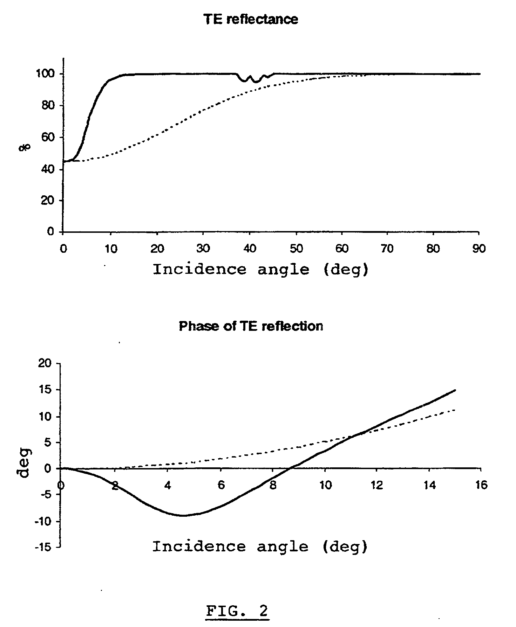

Figure 2 shows the TE reflectance, both amplitude (%) and phase (deg), of the system comprising said first stack and said second stack for normal incidence of said beam from the direction of said second stack. The full line shows the present invention, the dashed line shows the reflectance of a traditional DBR mirror. Here a vacuum wavelength of said beam is $\lambda_0 = 980$ nm, the refractive indices used in this embodiment are $n_1 = 1.55$, $n_2 = 3.5$. The negative equivalent penetration depth or negative phase is characteristic for the invention.

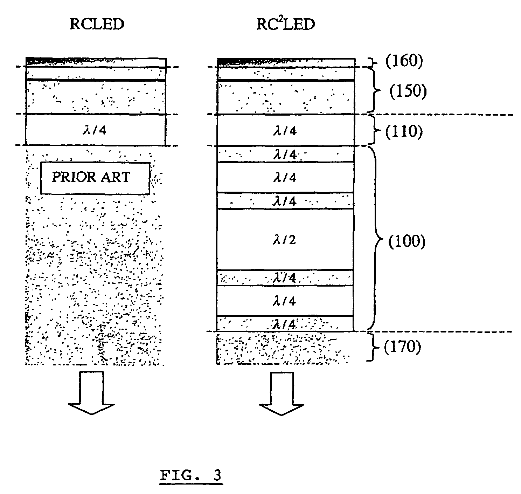

Figure 3 shows on the left prior art RCLED's and one the right a RCLED comprising the invented system, comprising a metal reflector, an electromagnetic radiation generating layer or cavity, a second stack, here comprising one dielectric layer, a first stack comprising a first substack, a second substack and a third substack. Said first and second substacks comprising here three dielectric layers, said third substack, comprising one dielectric layer. Said system is attached to a substrate (170).

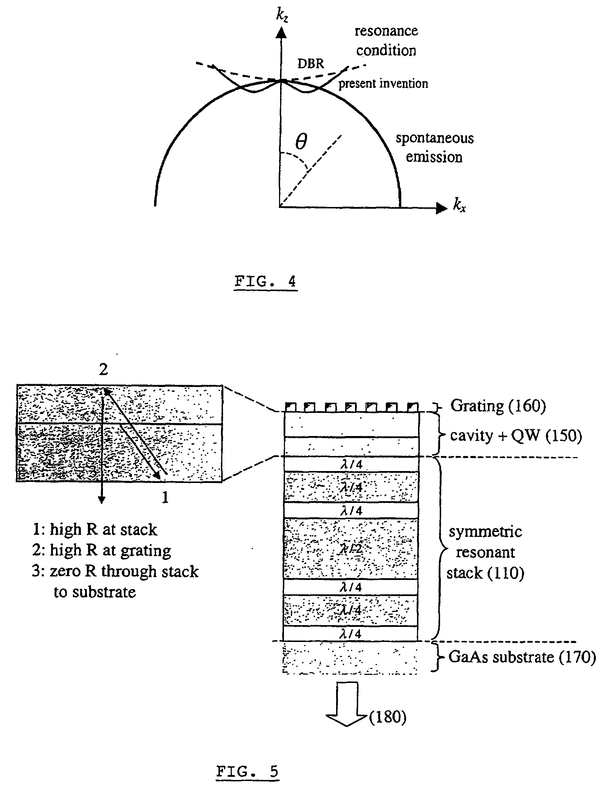

Figure 4 shows a schematic k-diagrams for a RCLED (prior art) (dotted line) and the invented system (full line). The negative equivalent penetration depth of the invented system results in at least more than one crossing of the circle representing spontaneous emission and the reflection characteristic of the system. Therefore at least more than one resonance condition is found.

Figure 5 shows an embodiment of the invention, exploiting a grating in order to enable resonance in a not normal direction. Said embodiment comprising said first stack, an electromagnetic radiation generating layer and a grating. As said first stack is transparent for normal incidence and highly reflective for not normal incidence, such decoupling between resonance in one direction and transporting the resulting electromagnetic radiation outside the cavity (180) towards the substrate (170) is enabled.

### Detailed description

Although detailed description and several embodiments of the invention are described below, the scope of the invention is determined only by the claims.

The invented system guides a beam of electromagnetic radiation. Said guiding of a beam can also be denoted transferring of a beam. Said system comprises planar media. Said system comprises a stack of dielectric layers with a plurality of refractive indices and thicknesses of said layers.

In said system at least a first stack of dielectric layers with the following properties can be distinguished. Said first stack comprising at least a first substack, a second substack and a third substack, separating said first and second substacks. Said first substack comprises a plurality of dielectric layers, said second substack comprises a plurality of dielectric layers. Dielectric layers of said first substack and said second substack having a same distance from said third substack are related to each other in the sense that at least they have the same refractive index. Moreover the sum of the thickness of dielectric layers of said first substack and said second substack having a same distance from said third substack is a multiple of half of the vacuum wavelength of said beam divided by the refractive index of said dielectric layers of said first substack and said second substack having a same distance from said third substack. In Figure 1 said first substack layers are denoted B layers, said second substack layers are denoted D layers and said third substack layers are denoted C layers. In Figure 1 said third substack layer comprises 1 layer but the invention is not limited thereto.

Said dielectric layers can be semiconducting material such as Al(x)Ga(1-x)As or InP but is not limited hereto. Dielectric layers with refractive indices in between 2.9 and 3.6 can be used but the invention is not limited hereto.

The thicknesses $d$ of the layers in said first (B) and second substack (D) satisfy the following relationships with $n_x$ designates said refractive index of layer $x$, while $\lambda_0$ designates the vacuum wavelength of said beam.

$$d_{Bl} + d_{Di} = k_i \frac{\lambda_0}{2n_{Bl}},$$

with $i = 1..m$ and $k_i = 1,2,...$

In a first embodiment of the invention the thickness d of said third substack C satisfies the relationship below. Said third substack comprises at least a dielectric layer with a refractive index $n_c$ with a thickness being equal to a multiple of half of the vacuum wavelength of said beam divided by $n_c$.

$$d_C = l \frac{\lambda_0}{2n_C},$$

with $l = 1,2,..$

Under these conditions, the normal incidence transfermatrix for said first stack is always the unit matrix, meaning that for said normal incidence said first stack is fully transparent or opaque.

In a second embodiment of the invention said system further comprises a second stack of dielectric layers. The number and thicknesses of the layers in said second stack are fully arbitrary. Figure 1 shows that said second stack is placed on top of said first stack and thus attached to said first stack. However in the invention alternative placements of said first and second stack are possible, for instance the placement of said first stack and said second stack can be interchanged.

Moreover, said sequence of layers consisting of said first stack and second stack can be repeated an arbitrary number of times, if necessary with different material parameters in each repetition.

In an embodiment of said second embodiment said system comprises thus a periodic repetition of said first and said second stack.

In a further embodiment of said second embodiment in said system with periodic repetitions, the refractive index of said dielectric layers are different for at least two repetitions.

In another embodiment of said second embodiment said system comprises at least a periodic repetition of said first stack.

In a further embodiment of said second embodiment in said system with periodic repetition of said first stack, the refractive index of said dielectric layers are different for at least two repetitions.

According to a third embodiment of the invention, the parameters of said stack of said dielectric layers, both said first stack and said second stack, are chosen such that they cooperatively establish a high reflectance of said beam for off-axis incidence, a moderate reflectance of said beam for normal incidence and a negative equivalent penetration depth upon reflection of said beam.

It can be emphasized that said first stack is designed for establishing a high reflectance of said beam for off-axis incidence and realizing a negative equivalent penetration depth upon reflection of said beam, while said second stack is designed for moderate reflectance of said beam for normal incidence. As such said second stack of dielectric layers can be characterised as being substantially reflective for normal incidence radiation. Said first stack of dielectric layers can be characterised as being substantially transparent for normal incidence radiation and substantially reflective for off-axis incidence radiation. In the invention a spatial decoupling of the functionalities can thus be recognized. Moreover the exploitation of the phase characteristic of said reflectance of such systems is not known in the art.

According to a further embodiment of said third embodiment, said parameters of said first stack are chosen such that the reflectance of said beam is zero for normal incidence, while being very high for off-axis incidence.

According to a further embodiment of said third embodiment, said stack exhibiting said high off-axis incidence reflectance, said moderate normal incidence reflectance and said negative equivalent penetration depth replaces a traditional DBR reflector in a microcavity light emitting diode. Said high off-axis incidence reflectance provides for a narrow radiation pattern, while said negative equivalent penetration depth creates additional resonances in the extraction cone, thereby boosting the extraction efficiency. As compared to traditional DBR reflectors, said reflectance as a function of angle of said stack is such that the existence of leaky modes is greatly suppressed, thereby increasing the efficiency of the photon recycling mechanism. Such system can be characterised in that it comprises at least one electromagnetic generating layer. Further said electromagnetic generating layer is attached at one side to said second stack of dielectric layers. The system is thus being adapted for operating as an electromagnetic emitting device.

According to yet another embodiment of said third embodiment, said first stack exhibiting said zero normal incidence reflectance and said high off-axis incidence reflectance is used as a zero-loss outcoupling mirror in a surface emitting microcavity device. In this particular embodiment, another periodic structure couples one or more guided modes to modes propagating in a direction being substantially normal to the surface. Said off-axis propagating guided modes experience high reflectance upon incidence of said outcoupling mirror, thereby leading to high cavity Q-factors.

According to a fourth embodiment of the invented system, said second stack of dielectric layers comprises an alternating sequence of dielectric layers with refractive indices $n_1$ and $n_2$. The thickness of each of said dielectric layers are a quarter of the vacuum wavelength of said beam divided by the refractive index of the corresponding dielectric layer. Said second stack of dielectric layers can be characterised as a traditional DBR stack of alternating layers with refractive indices $n_1$ and $n_2$, each having an optical thickness of a quarter wavelength.

According to a further embodiment of said fourth embodiment, said second stack of dielectric layers consists of a dielectric layer with refractive index $n_1$ and the thickness of said dielectric layer being a quarter of the vacuum wavelength of said beam divided by $n_1$.

According to a further embodiment of said fourth embodiment of the invented system, the first substack (B) of said first stack consists of a DBR with the same materials as said second substack, thus having said indices $n_1$ and $n_2$. Said first substack has an odd total number of layers m. Said third substack (C) has an optical thickness of half a wavelength, while said second substack (D) is then the mirror image of said first substack (B). Provided that said total number of layers m is large enough, and/or that the refractive index contrast in said first substack is large enough, said reflectance of said beam will exhibit a negative equivalent penetration depth, i.e. a negative slope of the phase of said reflection coefficient of said beam as a function of incidence angle in the area around normal incidence under the assumption of a *exp(jω t)* time convention. It is this negative equivalent penetration depth that one has to recognise for exploiting the invention in a microcavity LED.

In the special case said second stack consists of a single quarter-wavelength-layer (A) of material with said index $n_1$, and said first substack (B) consists of three quarter-wavelength-layers of alternating said indices $n_2$ -$n_1$ -$n_2$. Said third substack (C) is a half-wavelength-layer of material with said index $n_1$ while said second substack (D) has the same structure as said first substack (B). Figure 2 compares the reflection characteristics of said stack consisting of said sub-stacks A,B, C and D with those of a traditional DBR structure containing only said stack A and not said stacks B, C nor D. Both structures are embedded in a medium with said index $n_1$. Although for said characteristic said first stack and said second stack are not repeated, the invention is not limited thereto.

It is clear that the present invention yields much higher reflectivities for off-axis incidence, while still maintaining the possibility of an arbitrary reflectance for normal incidence by choosing the number of layers in said second stack A. This contrasts to said traditional DBR mirrors, where increasing the number of layers leads to increase in reflectivity for both said normal and said off-axis incidence. Moreover, the slope of said reflection characteristic as a function of incidence angle of said beam is different for the present invention as compared to a said traditional DBR, leading to a negative equivalent penetration depth.

In a particularly promising further embodiment, said structure from said fourth embodiment replaces a traditional DBR mirror in a microcavity light emitting device. This device is henceforth referred to as a RC2LED, while the known device with said DBR reflector is referred to as a RCLED. This device is henceforth referred to as a RC2LED, while the known device with said DBR reflector is referred to as a RCLED. Said name RC2LED stems from the presence of two resonant cavities (RC), one containing the electromagnetic generating region as in said RCLED, and one RC used in the reflector. The general properties of said two classes of devices are compared using the specific but not limiting examples of the devices outlined in Figure 3.

In a further particular but not limiting example, said devices are bottom emitting at 980 nm, have a top metal mirror (*n = 0.2 - 6.5 j*) doubling as a current contact, a 189 nm GaAs (*n = 3.5*) resonant cavity and a QW emitting at 980 nm placed at a field maximum. Said refractive indices in the bottom reflector are $n_1 = 1.55$ and $n_2 = 3.5$. Since the transmission of said structure is only significant in a small cone around normal incidence, the radiation pattern of said RC2LED will be much more narrow and directive as compared to said RCLED. Moreover, said negative equivalent penetration depth creates extra resonances in the extraction cone, leading to a higher extraction efficiency. The presence of extra resonances is further illustrated in fig. 4, comparing $k$-vector diagrams for said RCLED and said RC$^2$LED. Intersection points of the sphere representing spontaneous emission and of the surface representing the resonance condition correspond to resonantly enhanced emitted radiation. Both devices have a resonance for normal incidence ($\theta = 0$), but said RC$^2$LED exhibits a second resonance because of the negative equivalent penetration depth. The system can be characterised as a system being such that the equivalent penetration depth of said beam being negative.

The optical properties of said RCLED and said RC$^2$LED as outlined in said specific but not limiting example of fig. 3 were simulated assuming emitting dipoles oriented parallel to the interface in said stack, said dipoles having gaussian spontaneous emission spectrum with a FWHM of 45 nm centered at 980 nm, in the absence of a AR coating on the substrate and in the absence of the photon recycling effect. Both devices exhibit an extraction efficiency of about 18 %, but the radiation pattern of said RC$^2$LED is much narrower. For said RCLED, only 34 % of the light emitted into air falls within a NA of 0.5, whereas for said RC$^2$LED this figure is as high as 52 %. Furthermore, it is interesting to note that the phase of the reflection of said structure for normal incidence as a function of wavelength also exhibits a negative slope. This creates extra resonances in the wavelength domain, leading to an optical spectrum with multiple peaks. Moreover, in said RC$^2$LED, the presence of leaky modes is significantly suppressed as compared to said traditional RCLEDs, even when said RCLEDs use a larger number of pairs in said DBR. This increases the efficiency of the photon recycling effect. Note that the same degrees of freedom for device design such as changing the cavity length or changing the position of the active layer apply equally well to said RC$^2$LED as to said RCLED.

In a fifth embodiment of the invention, said second stack of dielectric layers, denoted stack A, is not present, leading to a structure, comprising said first stack, which is fully transparent for normal incidence of said beam, but exhibiting a high off-axis reflectance of said beam.

In a further embodiment the stack from the fifth embodiment is employed as a zero-loss outcoupling mirror in a surface emitting microcavity device. Said microcavity device furthermore contains a periodic structure coupling one or more guided modes to modes propagating in a direction being substantially normal to the surface. Said off-axis propagating guided modes experience high reflectance upon incidence of said outcoupling mirror, thereby leading to high cavity Q-factors, but at the same time providing for very low outcoupling loss.

The invented system can be described as a system for transferring a beam of electromagnetic radiation, said system comprising a stack of dielectric media with a plurality of refractive indices and thicknesses, said stack of said dielectric media containing one or more substacks exhibiting transparency upon normal incidence of said dielectric beam, the parameters of said system further being chosen such that they can cooperatively establish high reflectance upon off-axis incidence of said beam, arbitrary reflectance upon normal incidence of said beam and negative equivalent penetration depth of said beam. Said stack can be used as a mirror in a microcavity device. Said stack can also used as a mirror in a microcavity light emitting diode. Said mirror provides for a narrow radiation pattern and/or a high extraction efficiency.

Alternatively said invented system can be described as a system for transferring a beam of electromagnetic radiation, said system comprising a stack of dielectric media with a plurality of refractive indices and thicknesses, the parameters of said system further being chosen such that said stack of said dielectric media is fully transparent for normal incidence of said dielectric beam and such that said stack of said dielectric media has high reflectance for off-axis incidence. Said stack can again be used as a mirror in a microcavity device or as an outcoupling mirror in a surface emitting microcavity device. When using said stack in said microcavity device, said device can further contain a periodic structure coupling one or more guided modes to modes propagating in a direction being substantially normal to the surface.

The wavelength of electromagnetic radiation in the system according to the invention can be in the range of microwave radiation. Said system can also be integrated in microwave antenna's.

## Claims

1. A system designed for guiding a beam of electromagnetic radiation having a vacuum wavelength $\lambda_0$, said system comprising

   - a first stack (100) of dielectric layers, said first stack comprising

     - a first substack (120) of dielectric layers,
     - a second substack (130) of dielectric layers and
     - a third substack (140), separating said first and said second substack, and comprising at least one dielectric layer;

     wherein dielectric layers of said first substack (120) and said second substack (130) equidistant from said third substack (140) have the same refractive index;
     wherein the sum of the thickness of dielectric layers of said first substack and said second substack having a equidistant from said third substack is a multiple of half of the vacuum wavelength $\lambda_0$ divided by the refractive index of said dielectric layers;

wherein the thickness of said third substack is substantially different from a quarter of the vacuum wavelength $\lambda_0$ divided by the refractive index of said one dielectric layer of said third substack;

- wherein said first substack and said second substack each have an odd number of dielectric layers with refractive indices $n_1$ and $n_2$ which are substantially different such that the equivalent penetration depth of said beam is negative.

2. The system as recited in claim 1, wherein said first substack comprises a first and second layer with refractive index $n_2$, a third layer with refractive index $n_1$, said first and said third layer being attached to each other, said second and said third layer being attached to each other, said first and said second layer not being attached to each other.

3. The system as recited in claim 1, wherein said first substack is a concatenation of a first layer with refractive index $n_2$, a second layer with refractive index $n_1$ and a third layer with refractive layer $n_2$.

4. The system as recited in claim 3, wherein said third substack is a dielectric layer with index $n_1$.

5. The system as recited in claim 1, wherein said first stack of dielectric layers is substantially transparent for normal incidence radiation and substantially reflective for off-axis incidence radiation.

6. A system as recited in claim 1, with said third substack consisting of a single dielectric layer with a refractive index $n_c$ with a thickness equal to a multiple of half of the vacuum wavelength $\lambda_0$ divided by $n_c$.

7. A resonant cavity light emitting diode comprising a system as recited in claim 1, further comprising a second stack (110) of dielectric layers and at least one electromagnetic radiation generating layer (150), wherein one side of said electromagnetic radiation generating layer is attached to said second stack of dielectric layers.

8. The resonant cavity light emitting diode as recited in claim 7, wherein said second stack (110) of dielectric layers is in between said first stack of dielectric layers and said electromagnetic radiation generating layer.

9. The resonant cavity light emitting diode as recited in claim 7, where one side of said electromagnetic radiation generating layer is attached to said first stack of dielectric layers.

10. The resonant cavity light emitting diode as recited in claim 7 or 8, comprising a periodic repetition of said first and said second stack.

11. The resonant cavity light emitting diode as recited in claim 10, wherein the refractive index of said dielectric layers is different for at least two repetitions.

12. The resonant cavity light emitting diode as recited in claims 7 or 8, comprising at least a periodic repetition of said first stack.

13. The resonant cavity light emitting diode as recited in claim 12, wherein the refractive index of said dielectric layers is different for at least two repetitions.

14. A system or a resonant cavity light emitting diode as recited in any of -the previous claims, wherein said first stack of dielectric layers has a normal incidence matrix being substantially equal to the unit matrix.

15. A resonant cavity light emitting diode as recited in claim 7, wherein at least one layer of said first or second stack has a thickness substantially different from a quarter of the vacuum wavelength $\lambda_0$ divided by the refractive index of said layer of said first or second stack.

**Patentansprüche**

1. System, welches zum Führen eines Strahles einer elektromagnetischen Strahlung mit einer Wellenlänge $\lambda_0$ im Vakuum ausgelegt ist, wobei dieses System umfasst:

- einen ersten Stapel (100) von dielektrischen Schichten, wobei der besagte erste Stapel enthält:

  ➢ einen ersten Unterstapel (120) von dielektrischen Schichten,

  ➢ einen zweiten Unterstapel (130) von dielektrischen Schichten, und

  ➢ einen dritten Unterstapel (140), welcher jenen ersten und jenen zweiten Unterstapel voneinander trennt, und welcher mindestens eine dielektrische Schicht aufweist;

wobei die dielektrischen Schichten des besagten ersten Unterstapels (120) und des besagten zweiten Unterstapels (130), welche denselben Abstand von dem besagten dritten Unterstapel (140) aufweisen, denselben Brechungsindex besitzen;

wobei die Summe der Dicke der dielektrischen Schichten des besagten ersten Unterstapels und des besagten zweiten Unterstapels, welche denselben Abstand von dem besagten dritten Unterstapel aufweisen, ein Vielfaches darstellt von der Hälfte der Wellenlänge $\lambda_o$ im vakuum geteilt durch den Brechungsindex der besagten dielektrischen Schichten;

wobei die Dicke des besagten dritten Unterstapels wesentlich verschieden ist von einem viertel der Wellenlänge $\lambda_o$ im Vakuum geteilt durch den Brechungsindex der besagten einen dielektrischen Schicht des besagten dritten Unterstapels;

• wobei der besagte erste Unterstapel und der besagte zweite Unterstapel eine ungerade Anzahl von dielektrischen Schichten mit den Brechungsindices $n_1$ und $n_2$ aufweisen, welche sich im wesentlichen dadurch voneinander unterscheiden, dass die äquivalente Eindringtiefe des besagten Strahles negativ ist.

2. System gemäß Anspruch 1, wobei der besagte erste Unterstapel eine erste und eine zweite Schicht mit einem Brechungsindex $n_2$ und eine dritte Schicht mit einem Brechungsindex $n_1$ umfasst, wobei die besagte erste und die besagte dritte Schicht gegenseitig aneinander befestigt sind, wobei die besagte zweite und die besagte dritte Schicht gegenseitig aneinander befestigt sind und wobei die besagte erste und die besagte zweite Schicht nicht gegenseitig aneinander befestigt sind.

3. System gemäß Anspruch 1, wobei der besagte erste Unterstapel eine Verkettung von einer ersten Schicht mit dem Brechungsindex $n_2$, von einer zweiten Schicht mit dem Brechungsindex $n_1$ und von einer dritten Schicht mit einem Brechungsindex $n_2$ darstellt.

4. System gemäß Anspruch 3, wobei der besagte dritte Unterstapel aus einer dielektrischen Schicht mit dem Index $n_1$ besteht.

5. System gemäß Anspruch 1, wobei der besagte erste Stapel aus dielektrischen Schichten im wesentlichen durchlässig ist für eine normale einfallende Strahlung und im wesentlichen reflektierend ist für eine einfallende und von der Achse abweichenden Strahlung.

6. System gemäß Anspruch 1, wobei der besagte dritte Unterstapel aus einer einzelnen dielektrischen Schicht besteht mit einem Brechungsindex $n_c$ mit einer Dicke, welche die gleiche ist wie ein Vielfaches der Hälfte der Wellenlänge $\lambda_o$ im vakuum geteilt durch $n_c$.

7. Licht emittierende Diode mit einem Hohlraumresonator, welche ein System gemäß Anspruch 1 umfasst und welche ferner einen zweiten Stapel (110) von dielektrischen Schichten und mindestens eine eine elektromagnetische Strahlung erzeugende Schicht (150) umfasst, wobei eine Seite der besagten eine elektromagnetische Strahlung erzeugenden Schicht an dem besagten zweiten Stapel von dielektrischen Schichten befestigt ist.

8. Licht emittierende Diode mit einem Hohlraumresonator gemäß Anspruch 7, wobei der besagte zweite Stapel (110) von dielektrischen Schichten zwischen dem besagten ersten Stapel von dielektrischen Schichten und der besagten eine elektromagnetische Strahlung erzeugenden Schicht liegt.

9. Licht emittierende Diode mit einem Hohlraumresonator gemäß Anspruch 7, wobei eine Seite der besagten eine elektromagnetische Strahlung erzeugenden Schicht an dem besagten ersten Stapel von dielektrischen Schichten befestigt ist.

10. Licht emittierende Diode mit einem Hohlraumresonator gemäß den Ansprüchen 7 oder 8, welche eine periodische Wiederholung von dem besagten ersten und dem besagten zweiten Stapel umfasst.

11. Licht emittierende Diode mit einem Hohlraumresonator gemäß Anspruch 10, wobei der Brechungsindex der besagten dielektrischen Schichten für mindestens zwei Wiederholungen verschieden ist.

12. Licht emittierende Diode mit einem Hohlraumresonator gemäß den Ansprüchen 7 oder 8, welche mindestens eine periodische Wiederholung des besagten ersten Stapels umfasst.

13. Licht emittierende Diode mit einem Hohlraumresonator gemäß Anspruch 12, wobei der Brechungsindex der besagten dielektrischen schichten für mindestens zwei Wiederholungen verschieden ist.

14. System oder eine Licht emittierende Diode mit einem Hohlraumresonator gemäß irgendeinem der vorhergehenden Ansprüche, wobei der besagte erste Stapel von dielektrischen Schichten eine normale Inzidenzmatrix aufweist, welche im wesentlichen die gleiche ist wie die Einheitsmatrix.

15. Licht emittierende Diode mit einem Hohlraumresonator gemäß Anspruch 7, wobei mindestens eine Schicht des besagten ersten oder des besagten zweiten Stapels eine Dicke aufweist, welche im wesentlichen verschieden ist von einem Viertel der Wellenlänge $\lambda_o$ im Vakuum geteilt durch den Brechungsindex der besagten Schicht aus dem besagten ersten oder dem besagten zweiten Stapel.

## Revendications

1. Système conçu pour le guidage d'un faisceau d'un rayonnement électromagnétique présentant une longueur d'onde sous vide $\lambda_0$, ledit système comprenant:

   - un premier empilement (100) de couches diélectriques, ledit premier empilement comprenant:

     - un premier sous-empilement (120) de couches , diélectriques,
     - un deuxième sous-empilement (130) de couches diélectriques, et
     - un troisième sous-empilement (140), séparant ledit premier et ledit deuxième sous-empilements, et comprenant au moins une couche diélectrique;

     dans lequel les couches diélectriques dudit premier sous-empilement (120) et dudit deuxième sous-empilement (130) équidistants dudit troisième sous-empilement (140) possèdent le même indice de réfraction;
     dans lequel la somme des épaisseurs des couches diélectriques dudit premier sous-empilement et dudit deuxième sous-empilement équidistants dudit troisième sous-empilement est un multiple de la moitié de la longueur d'onde sous vide $\lambda_0$ divisée par l'indice de réfraction désdites couches diélectriques;
     dans lequel l'épaisseur dudit troisième sous-empilement est substantiellement différente d'un quart de la longueur d'onde sous vide $\lambda_0$ divisée par l'indice de réfraction de ladite une couche diélectrique dudit troisième sous-empilement;

     - dans lequel ledit premier sous-empilement et ledit deuxième sous-empilement possèdent chacun un nombre impair de couches diélectriques avec des indices de réfraction $n_1$ et $n_2$, qui sont substantiellement différents de sorte que la profondeur de pénétration équivalente dudit faisceau est négative.

2. Système selon la revendication 1, dans lequel ledit premier sous-empilement comprend une première et une deuxième couches avec un indice de réfraction $n_2$, une troisième couche avec un indice de réfraction $n_1$, ladite première et ladite troisième couches étant attachées l'une à l'autre, ladite deuxième et ladite troisième couches étant attachées l'une à l'autre, ladite première et ladite deuxième couches n'étant pas attachées l'une à l'autre.

3. Système selon la revendication 1, dans lequel ledit premier sous-empilement est une concaténation d'une première couche avec un indice de réfraction $n_2$, d'une deuxième couche avec un indice de réfraction $n_1$ et d'une troisième couche avec un indice de réfraction $n_2$.

4. Système selon la revendication 3, dans lequel ledit troisième sous-empilement est une couche diélectrique avec un indice $n_1$.

5. Système selon la revendication 1, dans lequel ledit premier empilement de couches diélectriques est substantiellement transparent pour un rayonnement d'incidence normale et substantiellement réfléchissant pour un rayonnement d'incidence décalée.

6. Système selon la revendication 1, ledit troisième sous-empilement étant constitué d'une seule couche diélectrique avec un indice de réfraction $n_c$ d'une épaisseur égale à un multiple de la moitié de la longueur d'onde sous vide $\lambda_0$ divisée par $n_c$.

7. Diode électroluminescente à cavité résonante comprenant un système selon la revendication 1, comprenant en outre un deuxième empilement (110) de couches diélectriques et au moins une couche générant un rayonnement électromagnétique (150), dans laquelle un côté de ladite couche générant un rayonnement électromagnétique est attaché audit deuxième empilement de couches diélectriques.

8. Diode électroluminescente à cavité résonante selon la revendication 7, dans laquelle ledit deuxième empilement (110) de couches diélectriques est entre ledit premier empilement de couches diélectriques et ladite couche générant un rayonnement électromagnétique.

9. Diode électroluminescente à cavité résonante selon la revendication 7, dans laquelle un côté de ladite couche générant un rayonnement électromagnétique est attaché audit premier empilement de couches diélectriques.

10. Diode électroluminescente à cavité résonante selon la revendication 7 ou 8, comprenant une répétition périodique dudit premier et dudit deuxième empilements.

11. Diode électroluminescente à cavité résonante selon la revendication 10, dans laquelle l'indice de réfraction desdites couches diélectriques est différent pour au moins deux répétitions.

**12.** Diode électroluminescente à cavité résonante selon la revendication 7 ou 8, comprenant au moins une répétition périodique dudit premier empilement.

**13.** Diode électroluminescente à cavité résonante selon la revendication 12, dans laquelle l'indice de réfraction desdites couches diélectriques est différent pour au moins deux répétitions.

**14.** Système ou diode électroluminescente à cavité résonante selon l'une quelconque des revendications précédentes, dans lesquels ledit premier empilement de couches diélectriques possède une matrice d'incidence normale qui est substantiellement égale à la matrice unité.

**15.** Diode électroluminescente à cavité résonante selon la revendication 7, dans laquelle au moins une couche dudit premier ou dudit deuxième empilement possède une épaisseur substantiellement différente d'un quart de la longueur d'onde sous vide $\lambda_0$ divisée par l'indice de réfraction de ladite couche dudit premier ou dudit deuxième empilement.

Figure 1

FIG. 1

**TE reflectance**

**Phase of TE reflection**

FIG. 2

RCLED            RC²LED

| | | |
|---|---|---|
| | | (160) |
| | | (150) |
| $\lambda/4$ | $\lambda/4$ | (110) |
| PRIOR ART | $\lambda/4$ | |
| | $\lambda/4$ | |
| | $\lambda/4$ | |
| | $\lambda/2$ | (100) |
| | $\lambda/4$ | |
| | $\lambda/4$ | |
| | $\lambda/4$ | |
| | | (170) |

FIG. 3

FIG. 4

1: high R at stack
2: high R at grating
3: zero R through stack
   to substrate

Grating (160)

cavity + QW (150)

$\lambda/4$
$\lambda/4$
$\lambda/4$
$\lambda/2$
$\lambda/4$
$\lambda/4$
$\lambda/4$

symmetric resonant stack (110)

GaAs substrate (170)

(180)

FIG. 5